# EUROPEAN PATENT APPLICATION

(11) **EP 0 543 399 A1**
(43) Date of publication of application: **26.05.1993**
(21) Application number: 92119810.7
(22) Date of filing: 20.11.1992
(51) Int. Cl.: H01L 39/14, H01L 39/24

(54) **Compound superconducting wire and method of producing the same**

(30) Priority: 20.11.1991 JP 304489/91
(71) Applicant: HITACHI, LTD., Chiyoda-ku, Tokyo 100 (JP)
(72) Inventor: Wadayama, Yoshihide, Hotachiota-shi (JP); Suzuki, Takaaki, Katsuta-shi (JP); Aihara, Katsuzo, Hitachiota-shi (JP); Tada, Naofumi, Hitachi-shi (JP)
(74) Representative: Patentanwälte Beetz - Timpe - Siegfried Schmitt-Fumian - Mayr

(57) **Abstract**

A superconducting wire having a high critical current density in a high magnetic field and an excellent magnetic stability together is provided by finely precipitating a superconductor of stoichiometric composition together with a normal conductor in an amorphous body or a supersaturated solid solution, which produces many filamentary superconductors contained in a metal sheath.

## Description

### BACKGROUND OF THE INVENTION

### Field of the Invention

The present invention relates to a compound superconducting wire and a process for producing the superconducting wire. More particularly, it provides a superconducting wire of an A15 compound such as Nb₃Al, Nb₃(Al, Ge), Nb₃Sn and (Nb, Ti)₃Sn, a B1 compound such as NbN and a Chevrel superconductor such as PbMo₆S₈ which have a high critical magnetic field and high critical current density and are used as a high magnetic field superconducting magnet for nuclear fusion and studying solid state properties, and a process for producing the superconducting wire.

### Description of Related Art

At present, fine multifilamentary wires of Nb₃Sn and (Nb, Ti)₃Sn are mainly used for making high magnetic field superconducting magnets for nuclear fusion and studying solid state properties. These superconducting wires for high magnetic field are required to have a high critical magnetic field and a high current density, but the Nb₃Sn superconductor has a critical magnetic field of at most about 20 T and is not enough for use in a high magnetic field. The Nb₃Al superconductor is one of A15 compound superconductors like Nb₃Sn superconductor, but since it has a high critical magnetic field, namely, 30-40 T, it has been noticed as a superconducting wire for high magnetic field of a next generation type.

However, the Nb₃Al compound has a wide range of composition and the compound is stable at a high temperature region of higher than 1900°C only when it has a stoichiometric composition of Nb:Al=3:1 which has a high critical magnetic field. As the temperature is lowered, the Al concentration decreases and also the critical magnetic field characteristics gets poor. Further, a conflicting condition between the heat treatment at high temperatures and the refining of crystal grains causes the crystal grains to be coarsened to damage the critical current density of the compound when subjected to the heat treatment at high temperatures. Therefore, in this art it has been a task to produce practical wires which surely possess the high characteristics.

Up to now, for obtaining the Nb₃Al superconducting compound there have been employed a process which comprises preparing a composite comprising metallic substances such as Nb and Al which constitute the compound, subjecting the composite to area reduction to form a continuous product and then subjecting the product to diffusion heat treatment (hereinafter referred to as "diffusion reaction process") and a process which comprises quenching a melt of the Nb₃Al compound or heating an Nb₃Al compound to a high temperature approximately close to the melting point thereof to produce a non-equilibrium phase comprising an Nb crystal structure in which Al is supersaturatedly dissolved to form a solid solution and, thereafter, subjecting the product to precipitation heat treatment (hereinafter referred to as "quenching precipitation process").

For example, with reference to the diffusion reaction process, there are the process which comprises packing the mixed powder of Nb and Al powders into a metal pipe and subjecting the pipe to area reduction and then to diffusion heat treatment (Japanese Patent Kokai (Laid-Open) No. 57-19909), the process which comprises winding thin sheets of Nb and Al around a metallic core, embedding a number of these cores in a metallic pipe and subjecting the pipe to area reduction and diffusion heat treatment (jelly roll process, S. Ceresara et al, "Superconducting properties of Nb₃Al formed at temperature lower than 1000°C", 5th Int. Conf. Magnet. Tech., P685 (1975)), and the process which comprises inserting alloy cores such as Al-Mg in an Nb pipe and subjecting the pipe to area reduction and diffusion heat treatment (Japanese Patent Kokai (Laid-Open) No. 2-51807).

The quenching precipitation process includes, for example, a process which comprises continuously coating a melt of an Nb-Al compound on a copper tape, quenching the coating to form a film of an Nb-supersaturated solid solution phase and then, heat treating the film to precipitate superconducting crystal grains (K. Togano et al, A15 Nb₃Al superconductors prepared by transformation from liquid quenched body-centered cubic phase, Appl. Phys. Lett., 41(2), 15 July 1982, pp. 199-201) and a process which comprises packing mixed powders of Nb and Al in a metal sheath, subjecting the metal sheath to area reduction, heat treating the metal sheath at a high temperature for a short time by electric heating to form a film of an Nb-supersaturated solid solution phase and then heat treating the film (C.H. Thieme et al, Nb₃Al wire produced by powder metallurgy and rapid quenching from high temperature, IEEE Trans. on Mag., Vol. 25, No. 2 (1989), pp. 1992-1995). Besides, there is a process for directly producing a fine A15 phase on a substrate by a plasma heating method (Japanese Patent Kokai (Laid-Open) No. 63-4030).

As an example of using amorphous powders for production of A15 superconductors, it has been reported that powders of a starting material containing at least 10 at% of Cu are once converted to an amorphous body by mechanical alloying process and, thereafter, the amorphous body is heat treated to produce an A15 superconductor in the Cu matrix (Japanese Patent Kokai (Laid-Open) No. 63-223101).

NbN B1 superconductors have a high critical magnetic field and excellent deformation resistance, but these are also hard and brittle like the A15 compound superconductors and thus cannot be directly processed to wires. Up to now, there is a report that wires have been produced in a tape form by a tape by a film-forming method such as a RF sputtering method (Mitsumasa Suzuki et al, High magnetic field superconducting properties of B1 NbN and A15 Nb₃Ge in the tape form, an annual report of 1987, Tohoku University, Research Institute for Metals, Institution for Development of Superconducting Materials).

Chevrel superconductors such as PbMo₆S₈ have a critical magnetic field of about 40 T which is higher than that of Nb₃Al and have been noticed as wires for generation of high magnetic field, but they are also hard and brittle like A15 superconductors and cannot be directly processed to wires. Hitherto, Pb, Mo and a sulfide of Mo are mixed and processed to wires and thereafter the PbMo₆S₈ Chevrel phase is produced by solid phase reaction (Kubo et al, Evaluation of small coils of PbMo₆S₈ wires, an annual report of 1990, Tohoku University, Research Institute for Metals, Institution for Development of Superconducting Materials).

In the case of wires produced by the abovementioned diffusion process, which depend on an interdiffusion distance between Nb and Al shortened by the area reduction process, the composition of superconducting crystals of superconducting filaments enclosed in a metal sheath shifts from the stoichiometric phase to an Al-deficient side, since the reaction temperature falls properly within the range of 900-1200°C for balancing between the critical magnetic field and the critical current density. Therefore, the critical magnetic field properties of the wires are also inferior. That is, the wires exhibit high critical current characteristics in a low magnetic field region but a critical current density lowered to a great extent in a high magnetic field. Furthermore, when the wires are subjected to high-temperature heat treatment, the crystal grains of the compound are coarsened and the critical current density lowers in the entire magnetic field region.

In order to further improve the high magnetic field characteristics of Nb₃Al superconductors, it is effective to add a third element such as Ge, Si or the like to form Nb₃(Al, Ge) or Nb₃(Al, Si). However, the processability of the superconductors with the diffusion reaction process is poor, accordingly, the characteristics of the superconducting phase are also inferior, even if Ge or Si is added to either one of Nb or Al, because the element added does not completely dissolve in Nb or Al and partially segregates and forms no complete solid solution, which may, however, depend on the added amount.

In the case of the superconducting wires produced by the quenching precipitation process, the inherent high characteristics of Nb₃Al can be secured, because the stoichiometric composition and the fining of crystal grains can mostly be attained at the same time. On the other hand, however, when an Nb-Al supersaturated solid solution is prepared by a melt quenching process, the quenching step requires the supersaturated solid solution as raw material to be limited in the tape form. Furthermore, a method in which the diffused pair of Nb and Al is instantaneously heated by electrical heating and quenching them, there are some problems that the portion heated electrically is not uniform in the lengthwise direction of wire and besides, when the wire is a multifilamentary wire, the cross-sectional configuration can hardly be maintained due to melting by electrical heating. Therefore, it is difficult to make a multifilamentary structure comprising a number of superconducting filaments excellent in magnetic stability as superconducting wires inserted in a stabilizing material such as copper.

For reducing the grain size of crystal grains of the superconducting compound to increase the critical current density, there is a process which comprises preparing an amorphous body comprising the elements such as Nb and Al and finely precipitating Nb₃Al or the like. However, for obtaining the amorphous body, the cooling rate must be at least 10⁵ °C/s in the case of the melt quenching process, and thin films or thin leaves only can be obtained by a conventional film forming process or melt spinning process, and further improvement is required for applying the process to production of practical wires. Furthermore, according to the process of producing a superconductor by adding 10 at% or more of Cu powders to the powders of elements which constitute the superconductor, making the mixture in an amorphous body by a mechanical alloying process and then heat treating the amorphous body, the electrical connection in the superconductor is not sufficient and besides the current-carrying capacity of the superconductor markedly decreases when formed in wire, because it takes a structure of a superconductor formed in the crystalline Cu matrix. In addition, there is such a problem that the Cu reacts with the superconductor at the time of heat treatment, resulting in partial deterioration of electric characteristics.

Furthermore, it is important for making superconducting magnets that the superconducting wires have a high critical current density in a high magnetic field. However, the flux pinning center of A15 superconductors is at grain boundary, and in order to further improve the pinning force in a high magnetic field, it is necessary to further finely disperse in the superconductor a normal conductor which constitutes the pinning center.

### SUMMARY OF THE INVENTION

The object of the present invention is to solve the above problems and to provide a superconducting wire having a high critical temperature and a high critical magnetic field.

### BRIEF DESCRIPTION OF DRAWINGS

Fig. 1 is a graph showing a relation between diffraction angle and intensity in the filament portion of the multifilamentary superconducting wire of the present invention.

Fig. 2 is a schematic view of a superconducting apparatus using the superconducting wire of the present invention.

### DETAILED DESCRIPTION OF PREFERRED EMBODIMENTS

In order to solve the above problems, the present invention provides a superconducting wire produced by packing an amorphous body comprising the elements which constitute the superconductor in a metal sheath, subjecting the sheath to area reduction and then heat treating the sheath to produce a superconductor in a fine form from the amorphous body, and a process for producing the superconducting wire. The composition of the amorphous body is desirably such that the superconductor to be produced has a stoichiometric composition, and the heat treating conditions are desirably controlled so that crystal grains have a size of 100 nm or less. Especially when the present invention is applied to superconducting wires necessary for making superconducting magnets which generate a high magnetic field, it is preferred that the superconductors are of A15 compounds such as Nb₃Sn, (Nb, Ti)₃Sn, Nb₃Al and Nb₃(Al, Ge). That is, the above A15 superconductors have a composition represented by A₃B in which A is an element selected from Group Va elements such as Nb, V and the like and B is an element selected from Groups IIIb and IVb elements such as Al, Ge, Ga, Si and the like and the elements A and B each may comprise not only a single element, but also a composite of these elements. Moreover, it is also desirable that the superconductors are of B1 compounds such as NbN or Chevrel type superconducting materials such as PbMo₆S₈.

Furthermore, it is effective for improving the critical current density of superconductors to finely disperse a normal conductor in the superconductors, because the normal conductor acts as flux pinning center. However, if the amount of the normal conductor dispersed is large, the effective sectional area of the superconductor is reduced and hence the amount of the normal conductor dispersed is desirably 1-9 vol%. It is further desired that the normal conductor is finely precipitated together with superconductor from an amorphous body or supersaturated solid solution which is a precursor of the superconductor. It is suitable for improvement of the critical current density that the normal conductor has a size of about 50 nm and a dispersion spacing of 100 nm or less. The normal conductor to be dispersed may be a precipitate of a single element which constitutes the superconductor or may be an alloy or a compound containing the element. Alternatively, it is also effective to form a wire using a precursor obtained by forming an amorphous body or a supersaturated solid solution from an element constituting a superconductor and another element which forms no solid solution in an equilibrium state together with the superconductor-constituting element by a mechanical alloying process and then finely precipitate the another element added together with the superconducting-constituting element in the superconductor by equilibrium heat treatment. In addition, it is also effective to add oxide particles as the normal conductor to be dispersed in the superconductor to the precursor, prior to the step of packing in a metal sheath the precursor from which the superconductor is produced.

As a process for producing the precursor comprising the superconductor-constituting elements, which is an amorphous body or a supersaturated solid solution from which the superconductor is produced, it is suitable to apply the mechanical alloying process to the powders of these elements or to quench these elements in a molten state or at a high temperature near the melting point. For avoiding surface oxidation of the precursor powder prepared by the mechanical alloying process, the precursor powder may be subjected to heat treatment in a hydrogen stream and then to dehydrogenation treatment under vacuum. This heat treatment as pretreatment is desirably carried out at so a relatively low temperature that the superconductor is not formed in the precursor.

As the metal sheath for making a continuous wire from the precursor, it is suitable to use copper or copper alloys, aluminum or the like which are superior in electrical and thermal conductivity. If a reaction is possible to take place at the interface between the precursor and the metal sheath during the heat treatment carried out for forming the superconductor from the precursor, damaging the characteristics of the resulting superconductor, then it is also effective to provide an intermediate layer of a metal having an excellent workability and a high melting point, such as Nb and Ta, between the precursor and the metal sheath.

Furthermore, in a process for heat treatment of a multifilamentary composite wire made by drawing in wires the metal sheaths in which a non-equilibrium body such as amorphous body or supersaturated solid solution is packed, not only a usual heat treatment in a vacuum or an inert gas but also a hot isotropic heat treatment is effective for improvement in densification and sinterability of the inner portion of the wires.

The action will be explained in detail below. Since the superconductor according to the present invention is produced from a precursor comprising a non-equilibrium body such as an amorphous body or supersaturated solid solution, the crystal grains of the resulting superconductor are very fine, and it is imparted with a high critical magnetic field and a high critical current density by controlling the composition of the precursor to the stoichiometric composition of the superconductor. The non-equilibrium body means an amorphous phase having no specific crystal lattice and a solid solution of a compound comprising the elements represented by the compositional formula A₃B in which the element B is supersaturatedly dissolved in the crystal lattice of the element A. The amorphous phase and supersaturated solid solution show such a phase of high free energy as obtained by quenching a melt of A₃B.

The heat treatment for producing the superconductor from the precursor should be controlled to such conditions that the composition approximates to the stoichiometric composition and the crystal grains are fine. That is, if the heat treating temperature is too high or the heat treating time is too long, the resulting superconductor having the stoichiometric composition further changes to a stable phase having a different compositional ratio and besides the crystal grains become coarser. The heat treatment for producing the superconductor may not be carried out until the precursor has become completely a superconducting phase, but may be stopped when the superconductor is in such a state that an intermediate phase is partially contained in which the precursor is being crystallized to the superconductor, whereby a superconductor comprising very fine crystal grains can be obtained. However, if the crystallization is insufficient, the superconducting characteristics are inferior and especially, critical current performance cannot be enhanced and hence the proportion of the intermediate phase in which the precursor is being crystallized to the superconductor, is desirably about 0.5-10% by volume. Furthermore, the fine dispersion of a normal conducting phase in the superconductor allows the normal conducting phase to act as a flux pinning center, whereby the critical current density in a high magnetic field is further enhanced.

Especially when the composition of the amorphous body in Nb-Al ranges from Nb-30at%Al to Nb-50at%Al, the normal conductor such as Nb₂Al is finely precipitated during the heat treatment for producing the superconductor due to the excessive Al and, therefore, it is especially effective to utilize this precipitates as a flux pinning center.

These effects of improving the high magnetic field characteristics of the superconductors brought about by the invention can be applied not only to the Nb₃Al compounds but also to A15 superconducting compounds such as Nb₃Sn compounds, B1 superconducting compounds such as NbN compounds, Chevrel compounds such as PbMo₆S₈ and furthermore alloy superconductors such as NbTi.

Furthermore, when the mechanical alloying process is applied to the process for synthesizing the precursor of the superconductor comprising the non-equilibrium phase in the present invention, metal elements such as Nb and Al can be alloyed without melting and hence the composition is easily controlled. That is, in the case where the melting technique is used, Al is evaporated upon heating at high temperatures owing to the great difference in the melting point between Nb and Al, and the alloy composition does not meet with that of the charged composition. However, according to the present invention, the raw material powders can be alloyed without melting in a closed container and so the alloy composition meets that of the charged composition.

The mechanically alloyed Nb-Al powders are in a very active state, and when there is the fear of surface oxidation, the powders are heat treated in a hydrogen atmosphere and then again heat treated for dehydrogenation under vacuum, whereby the surface oxidation can be avoided.

Since the superconducting crystal grains are produced by precipitation in the present invention, the superconducting phase is directly formed from the precursor of the amorphous body or supersaturated solid solution, and formation of compounds such as NbSn₃ and Nb₂Al different in compositional ratio are not experienced at the interface of the Nb and Al composite and no such compounds are present, as in superconducting filaments obtained by diffusion reaction. Therefore, the composition of the superconducting filament is uniform in the radial direction and the whole area of the filament can have excellent superconducting characteristics. This action is the same for Nb₃Sn superconducting wires obtained by diffusion reaction of Nb and Nb-Sn alloy.

Since the superconducting wire according to the present invention has excellent critical current characteristics in a high magnetic field, when a superconducting magnet made by winding the superconducting wire in the form of a coil is used together with an electric source for excitation of the superconducting magnet or a cryostat which is a liquid helium container, superconducting magnet devices which can generate high magnetic field can be produced. Furthermore, by providing a high frequency cavity, a waveguide or the like in the internal space of the superconducting magnet, it is also possible to make a nuclear magnetic resonance apparatus having an electromagnetic wave emitting unit which irradiates a subject with an electromagnetic wave.

The present invention will be in detail illustrated with reference to the following examples.

### Example 1

A Nb powder having a particle size of 40 µm and an Al powder having a particle size of 20 µm were weighed at an atomic ratio of Nb:Al=3:1 (Nb:14.88 g, Al:1.44 g) and were enclosed in an agate-made ball mill container together with agate-made balls in Ar gas of high purity. The internal volume of the ball mill container was 250 cc, the weight of the balls was 163 g and the weight ratio of the balls and the raw material powders was balls:powders=10:1. This ball mill container was put in a planetary ball mill and mixing and milling were carried out at a revolution rate of about 400 rpm for 55 hours. Then, the mixed and milled Nb and Al powders were taken out in a globe box of a high purity Ar gas atmosphere. Identification by X-ray diffractometry of crystal phase of the resulting powders revealed only the diffraction line of Nb, which was confirmed to be a non-equilibrium Nb containing 25 at% of Al supersaturatedly dissolved in solid solution.

The resulting powders were packed in an Nb pipe of 7 mm in outer diameter, 5 mm in inner diameter and 300 mm in length, and the both ends were sealed. The packing of the powders was carried out in a globe box of a high purity Ar gas atmosphere. This Nb pipe was further covered with a Cu pipe and subjected to hydrostatic extrusion and then to area reduction to make a wire. The resulting seven wires were bundled and again inserted in another Cu pipe and the pipe was subjected to area reduction. The resulting wire was enclosed in a quartz tube in an Ar atmosphere and heat treated at 900°C for 5 hours. The crystal phase of the charge in the wire was identified at microportions by micro X-ray diffractometry to find that an Nb₃Al superconducting compound was precipitated in a non-equilibrium supersaturated solid solution. The precipitated compound had an average particle size of about 50 nm. The filament diameter was about 100 µm. The superconducting wire had a critical current density of 315 A/mm² (temperature: 4.2 K, magnetic field: 20 T) and exhibited good characteristics in a high magnetic field.

When the powder-initially-packed sheath was copper, the packed Nb-Al powder reacted with the copper to damage the performance of the superconductor and, as a result, the critical current density was only 153 A/mm². When the sheath was Ta, there occurred no change in workability and superconducting characteristics after the heat treatment, and nearly the same results were obtained as in the case of the Nb sheath.

### Example 2

A Nb powder and Al powder were weighed at an atomic ratio Nb:Al=3:1 (Nb:2.97 g, Al:0.29 g) and were mixed and milled in the same manner as in Example 1, except that the weight ratio of balls and the raw material powders was changed to ball:powder=50:1. The crystallinity of the resulting powders was identified by X-ray diffractometry to find that it was a crystal phase close to an amorphous state, except that a weak diffraction line of non-equilibrium Nb in which 25 at% of Al dissolved in solid solution was partially found.

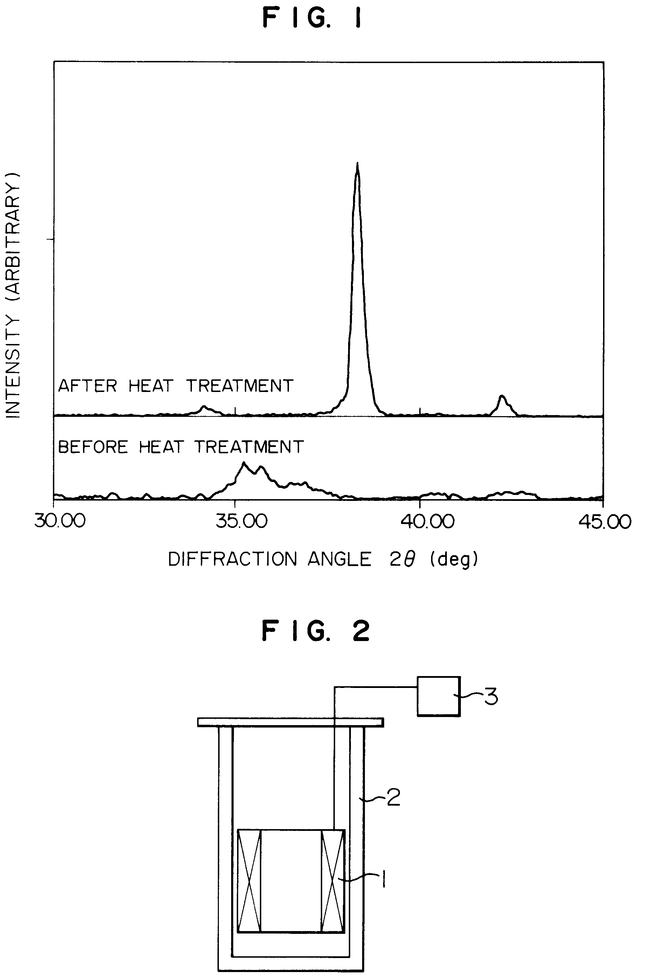

The resulting powders were formed in a wire in the same manner as in Example 1 and the wire was enclosed in a quartz tube in an Ar atmosphere and heat treated at 900°C for 5 hours. The crystal phase of the charge in the wire was identified at microportions by micro X-ray diffractometry to find that a superconducting compound was precipitated in an amorphous body (Fig. 1). The precipitated compound had an average particle size of about 30 nm. The resulting superconducting wire had a critical current density of 290 A/mm² (temperature: 4.2 K, magnetic field: 20 T) and exhibited good characteristics in a high magnetic field.

Moreover, the area-reduced wires were heat treated under different conditions to examine a dependency of the amount of the superconducting phase produced or the critical current density on the heat treating conditions. As a result, when the heat treating time was set at 24 hours, the proportion in volume of the superconducting phase was about 70% and the critical current density was 120 A/mm² at a heat treating temperature of 720°C, while the proportion was 90% and the critical current density was very high, namely, 250 A/mm² at 750°C. The proportion in volume of the superconducting phase and the amorphous body or the intermediate phase in which the amorphous body was changing to the superconductor was calculated from the area ratio obtained by observing the inner structure of the packed and treated powders by a transmission electron microscope.

### Example 3

A Nb powder of 40 µm in particle size, an Al powder of 20 µm in particle size and a Ge powder of 20 µm in particle size were weighed at an atomic ratio Nb:Al:Ge=3:0.75:0.25 and were mixed and milled in the same manner as in Example 1, except that the weight ratio of the balls and the raw material powders was ball:powder=10:1. The crystallinity of the resulting powders was identified by X-ray diffractometry. As a result, only the diffraction line of Nb was found, which was confirmed to be a non-equilibrium Nb containing 20 at% of Al and 5 at% of Ge supersaturatedly dissolved in solid solution.

The resulting powders were formed in a wire in the same manner as in Example 1 and the wire was enclosed in a quartz tube in an Ar atmosphere and heat treated at 950°C for 1 hour.

The crystal phase of the charge in the wire was identified at microportions by micro X-ray diffractometry to find that an Nb₃(Al, Ge) superconducting compound was precipitated in a non-equilibrium supersaturated solid solution. The resulting superconducting wire had a critical current density of 345 A/mm² (temperature: 4.2 K, magnetic field: 20 T) and exhibited good characteristics in a high magnetic field.

When the weight ratio of the balls and the raw material powders was ball:powder=50:1 in this example, amorphous powders were obtained. When the resulting powders were formed in a wire and heat treated in the same manner as above, a critical current density of 333 A/mm² (temperature: 4.2 K, magnetic field: 20 T) was obtained.

### Example 4

A Nb powder having a particle size of 40 µm was enclosed in an agate-made ball mill container together with agate-made balls in a nitrogen gas atmosphere. The weight of the balls was 163 g and the weight ratio of the balls and the Nb powders was balls:powders=50:1. This ball mill container was provided in a planetary ball mill in which mixing was carried out at a revolution rate of about 400 rpm for 30 hours with filling the container with nitrogen gas. Identification by X-ray diffractometry of the crystal phase of the powders obtained here revealed a very weak crystalline peak of Nb, which showed that it was an amorphous body. Compositional analysis showed that the powders contained about 50 at% of nitrogen. The resulting powders were formed into a wire in the same manner as in Example 1. The wire was heat treated at about 900°C for 1 hour. The crystallinity of the charge in the wire was identified at microportions by micro X-ray diffractometry to find that it was NbN. The resulting superconducting wire had a critical current density of 200 A/mm² (temperature: 4.2 K, magnetic field: 20 T).

### Example 5

Powders of Pb, Mo and Mo sulfide having a particle size of about 40 µm were weighed at an atomic ratio Pb:Mo:S=1.1:6:7.8 and were mixed and milled in the same manner as in Example 1, except that the weight ratio of the balls and the raw material powders was changed to ball:powder=50:1. The crystallinity of the resulting powders was identified by X-ray diffractometry to find that it was an amorphous phase. The resulting powders were formed into a wire in the same manner as in Example 1 and the wire was enclosed in a quartz tube in an Ar atmosphere and heat treated at 950°C for 1 hour. The crystal phase of the content in the wire was identified by micro X-ray diffractometry to find that a PbMo₆S₈ superconducting compound was precipitated in an amorphous body. The resulting superconducting wire had a critical current density of 350 A/mm² (temperature: 4.2 K, magnetic field: 20T) and exhibited good characteristics in a high magnetic field.

### Example 6

A Nb powder of 40 µm in particle size and an Al powder of 20 µm in particle size were weighed at an atomic ratio Nb:Al=3:2 (Nb: 14.88 g, Al: 2.88 g) and were mixed and milled in the same manner as in Example 1, except that the weight ratio of the balls and the raw material powders was ball:Powder=50:1. The crystallinity of the resulting powders was identified by X-ray diffractometry. As a result, it was confirmed that the phase was close to the amorphous phase, except that the very weak diffraction line of Nb was partially found.

The resulting powders were formed in a wire in the same manner as in Example 1 and the wire was enclosed in a quartz tube in an Ar atmosphere and heat treated at 950°C for 5 hours. The crystal phase of the charge in the wire was identified at microportions by micro X-ray diffractometry to find that the Nb₃Al superconducting compound and normal conductor Nb₂Al were precipitated from the amorphous body. The resulting superconductor had a critical current density of 315 A/mm² (temperature: 4.2 K, magnetic field: 20 T) and exhibited good characteristics in a high magnetic field.

### Example 7

A Nb powder and Sn powder were weighed at an atomic ratio of 3:1 and were mixed and milled in the same manner as in Example 1, except that the weight ratio of the balls and the Nb powders was ball: powders=50:1. The crystallinity of the resulting powders was identified by X-ray diffractometry to find that a crystalline phase close to amorphous phase was obtained.

The resulting powders were formed into a wire in the same manner as in Example 1 and the wire was enclosed in a quartz tube in an Ar atmosphere and heat treated at 900°C for 5 hours. The crystal phase of the content in the wire was identified by micro X-ray diffractometry to find that a superconducting compound was produced and precipitated in an amorphous body. The precipitated compound had an average particle size of about 30 nm. The resulting superconductor wire had a critical current density of 240 A/mm² (temperature: 4.2 K, magnetic field: 20 T) and good characteristics were obtained in a high magnetic field.

### Example 8

A Nb powder of 40 µm in particle size and an Al powder of 20 µm in particle size were weighed at an atomic ratio of Nb:Al=3:1. Furthermore, to the mixture of the Nb and Al powders was added an SiO₂ powder of about 1 µm in particle size in an amount of 3 vol% based on the mixture, and the mixture was mixed and milled in the same manner as in Example 1, except that the weight ratio of balls and the raw material powders was ball:powders=10:1. The crystal phase of the resulting powders was identified by X-ray diffractometry and, as a result, a non-equilibrium Nb containing 25 at% of Al supersaturatedly dissolved in solid solution and a weak peak of the added SiO₂ were found.

The resulting powders were formed in a wire in the same manner as in Example 1 and the wire was enclosed in a quartz tube in an Ar atmosphere and heat treated at 900°C for 5 hours. The crystal phase of the charge in the wire was identified at microportions by micro X-ray diffractometry to find that a superconductor was produced and precipitated and coexisted with the added SiO₂ particles. The precipitated compound had an average particle size of about 30 nm. The SiO₂ powder were finely divided to about 40 nm in particle size and uniformly dispersed in the superconducting layer. The resulting superconducting wire had a critical current density of 340 A/mm² (temperature: 4.2 K, magnetic field: 20 T). The relation between the critical current characteristics and the added amount of SiO₂ was examined to find that the characteristics were improved with increase of the added amount, but when volume ratio of SiO₂ after heat treatment exceeded 10%, the characteristics inversely deteriorated. The critical current characteristic was 315 A/mm² when the volume ratio was 0%, 330 A/mm² when it was 5%, 340 A/mm² when it was 10% and 275 A/mm² when it was 15%.

### Example 9

The wire before heat treatment made in the same manner as in Example 3 was wound in a coil to make a superconducting magnet (Fig. 2). The steps for making a magnet will be explained below. The wire was insulated with braided quartz fibers and then wound around a stainless steel bobbin. The coil had an inner diameter of 40 mm, an outer diameter of 100 mm and a turning number of 4800. The resulting coil was heat treated at 950°C for 1 hour and then vacuum impregnated with epoxy resin. This coil was placed in a superconducting magnet capable of generating a magnetic field of 18 T and excited in a liquid helium. As a result, a magnetic field of 20 T at maximum could be generated inside the coil keeping the superconducting state in a magnetic field of 18 T and thus, it was confirmed that the superconducting magnet had excellent performances.

According to the present invention, a superconducting wire can be obtained which comprises a stabilizing metal and many superconducting filaments contained therein and is magnetically stable and in which the superconducting portion has a stoichiometric composition having a high critical magnetic field and a high critical current density with fine crystal grains.

## Claims

1. A compound superconducting wire, which comprises a metal sheath and, contained therein, a plurality of superconductors produced from a precursor of non-equilibrium phase comprising at leat two elements.

2. A compound superconducting wire, the superconductors of which each comprises at least two elements and is in a form of filament, the composition of the superconductor filament being uniform throughout the whole of the filament.

3. A compound superconducting wire, which comprises a metal sheath and a plurality of superconductors contained in said sheath and crystallized by heat treating an amorphous body comprising at least two elements.

4. A compound superconducting wire, which comprises a metal sheath and a plurality of superconductors contained in said sheath and produced by heat treating an amorphous body comprising at least two elements, said superconductors containing 0.5-9 vol% of said amorphous body or an intermediate phase in which the amorphous body is to be crystallized to said superconductors.

5. A compound superconducting wire, which comprises a metal sheath and a plurality of superconductors contained in said sheath and precipitated by heat treating a solid solution comprising at least two elements.

6. A compound superconducting wire, which comprises a metal sheath and a plurality of superconductors contained in said sheath and precipitated by heat treating a solid solution comprising at least two elements, said superconductors containing 0.5-9 vol% of said solid solution or an intermediate phase in which the solid solution is to change to the superconductors.

7. A compound superconducting wire, which comprises a metal sheath and a plurality of superconductors contained in said sheath and produced by heat treating a precursor of an amorphous body or a solid solution comprising at least two elements, said superconductors containing 1-9 vol% of a normal conductor which does not damage the electric properties upon reacting with the superconductors during the heat treatment.

8. A compound superconducting wire according to any one of claims 1-7, wherein the composition of the superconducting phase produced from the amorphous body or of the solid solution approximates to the stoichiometric composition calculated from the crystal structure thereof, and the crystal grain size thereof is 5-100 nm.

9. A compound superconducting wire according to any one of claims 1-7, wherein the superconductor is an A15 compound represented by the formula AₓB_{y} wherein A is at least one metal selected from the metals of Group Va such as Nb, V and the like, B is at least one metal selected from the metals of Groups IIIb and IVb such as Al, Ge, Si, Ga and the like and x and y are in the ranges of 0.73 ≦ x ≦ 0.78 and 0.22 ≦ y ≦ 0.27.

10. A compound superconducting wire according to any one of claims 1-7, wherein the superconductor is an A15 compound represented by the formula AₓB_{y}C_{z} wherein A is Nb, B is Al, C is at least one metal selected from Ge and Si and x, y and z are in the ranges of 0.73 ≦ x ≦ 0.78, 0.15 ≦ y ≦ 0.22 and 0.03 ≦ z ≦ 0.10.

11. A compound superconducting wire according to any one of claims 1-7, wherein the superconductor is a B1 compound represented by the formula ABₓC_{y} wherein A is a metal of Group Va such as Nb and the like, B is N, C is C and x and y are in the ranges of 0.05 ≦ x ≦ 0.5 and 0.5 ≦ y ≦ 0.95.

12. A compound superconducting wire according to any one of claims 1-7, wherein the superconductor is a Chevrel compound represented by the formula AₓB_{y}C_{z} wherein A is Pb, B is Mo, C is S and x, y and z are in the ranges of 0.9 ≦ x ≦ 1.2, 5.5 ≦ y ≦ 6.5 and 7.5 ≦ z ≦ 8.5.

13. A compound superconducting wire according to any one of claims 1-7, wherein the superconductor is an A2 compound represented by the formula AₓB_{y} wherein A is Nb, B is at least one metal selected from Ti, Zr and Hf and x and y are in the ranges of 0.5 ≦ x ≦ 0.7 and 0.3 ≦ y ≦ 0.5.

14. A compound superconducting wire according to any one of claims 1-7, wherein the composition of the amorphous body approximates to the stoichiometric composition of the superconductor.

15. A compound superconducting wire according to claim 7, wherein the size and the dispersion spacing of the normal conductor is about 10-50 nm and 10-100 nm, respectively.

16. A compound superconducting wire according to claim 7, wherein the normal conductor which coexists with the superconductor comprises the elements constituting the superconductor.

17. A compound superconducting wire according to claim 7, wherein the normal conductor which coexists with the superconductor does not form a solid solution with the elements constituting the superconductor in an equilibrium state.

18. A compound superconducting wire according to claim 7, wherein the normal conductor which coexists with the superconductor is an oxide particle.

19. A compound superconducting wire according to any one of claims 1-7, wherein the metal sheath containing the superconducting filaments is of copper or a copper alloy.

20. A compound superconducting wire according to any one of claims 1-7, wherein an intermediate layer comprising a metal such as Nb, Ta or the like which is different from the metal of the metal sheath.

21. A method of producing a compound superconducting wire, which comprises the steps of forming a powder of an amorphous body or a solid solution from a mixture of at least two elements by a mechanical alloying process, packing the resulting powder into a metal sheath, subjecting the sheath to an area reduction to make a fine wire, inserting a plurality of the resulting fine wires into another metal sheath, and subjecting the another sheath to area reduction, these two latter steps being repeated a plurality of times to obtain a multifilamentary composite wire, which wire is then subjected to heat treatment in the final step to produce a superconducting phase in a filamentary non-equilibrium form.

22. A method of producing a compound superconducting wire, which comprises the steps of quenching a melt of an alloy comprising at least two elements to form an amorphous body or a solid solution, packing the resulting amorphous body or solid solution in a metal sheath, subjecting the sheath to an area reduction to make a fine wire, inserting a plurality of the fine wires into another metal sheath, and subjecting the another sheath to area reduction, these two latter steps being repeated a plurality of times to obtain a multifilamentary composite wire, which wire is then subjected to heat treatment in the final step to produce a superconducting phase in filamentary non-equilibrium form.

23. A method of producing a compound superconducting wire, which comprises heat treating a precursor of an amorphous body or a solid solution comprising at least two elements, adding oxide particles to the resulting amorphous body or solid solution, mixing them, packing the mixture in a metal sheath, subjecting the seath to area reduction, and then heat treating the sheaths.

24. A method of producing a compound superconducting wire according to claim 21, wherein prior to the step of packing the powders obtained by the mechanical alloying process in a metal sheath, the powders are subjected to heat treatment at a temperature of 250-500°C in a hydrogen stream and then to dehydrogenation heat treatment under vacuum.

25. A method of producing a compound superconducting wire according to claims 21 or 22, wherein the heat treatment after packing the powders of the amorphous body or the solid solution in a metal sheath and subjecting the sheath to the area reduction, is carried out in an inert gas atmosphere and at a temperature of 600-1000°C.

26. A superconducting apparatus, comprising a superconducting magnet comprising a compound superconducting wire wound in the form of a coil, which wire comprises a metal sheath containing a number of filaments as produced by heat treating an amorphous body or a solid solution comprising at least two elements; an electric source for exciting said superconducting magnet; and a cryostat for immersing the superconducting magnet in a cryogenic refrigeration medium.
